# EUROPEAN PATENT APPLICATION

(11) **EP 0 692 556 A1**
(43) Date of publication of application: **17.01.1996**
(21) Application number: 95401670.5
(22) Date of filing: 12.07.1995
(51) Int. Cl.: C30B 23/06

(54) **K cell type vapor source and shutter**

(30) Priority: 12.07.1994 JP 182882/94
(71) Applicant: Sumitomo Electric Industries, Ltd., Osaka 541 (JP)
(72) Inventor: Nakamura, Takao, Cabinet Ballot-Schmit, F-75116 Paris (FR); Iiyama, Michitomo, Cabinet Ballot-Schmit, F-75116 Paris (FR)
(74) Representative: Ballot, Paul Denis Jacques

(57) **Abstract**

This invention relates to a K cell type vapor source used for film deposition by a MBE method and a reactive co-evaporation. The K cell comprises a crucible, a small orifice above the crucible through which the crucible emits a molecular beam, and a shutter which substantially opens and closes the small orifice so as to control the molecular beam. According to the present invention, the crucible radiates sufficient heat so as to prevent overheating when the shutter is closed so that the crucible emits a stable molecular beam immediately after the shutter is opened.

## Description

### Background of the Invention

### Field of the invention

The present invention relates to a Knudsen cell (abbreviated as K cell hereinafter) type vapor source, and more specifically to a K cell type vapor source for film deposition by a molecular beam epitaxy (abbreviated MBE hereinafter) method and a reactive co-evaporation method.

### Description of related art

A MBE method is an improved vacuum evaporation method in which thin films are grown on a substrate by emitting molecular beams under an ultra high vacuum of on the order of 10⁻⁸ torr. The MBE method is developed for depositing thin films of compounds constituted of plural elements having different vapor pressures. Plural vapor sources of which temperatures can be independently controlled are used for depositing a thin film in the MBE method. Intensity of a molecular beam, namely supply rate of molecular of each vapor source is controlled by a temperature of the vapor source. Therefore, it is possible to accurately control deposition rates of thin films and compositions of compounds of thin films. It is also possible to prepare thin films having atomically planar surfaces and to deposit thin films atomically layer by layer, so that planar and crystalline thin films having complicated structures can be obtained by the MBE method. Even thin films of single crystals which cannot be obtained under thermal equilibrium state can be prepared the MBE method. In addition, growing surfaces of thin films can be observed in-situ by using devices for surface analysis during deposition process.

A reactive co-evaporation method is one of the MBE methods in which all the molecular beams are simultaneously emitted to a substrate so that a thin film is formed on the substrate by reaction near its surface. A reaction gas such as an oxidation gas is supplied in vicinity of the substrate, if necessary. The reactive co-evaporation method is suitable for depositing oxide superconductor thin films having high crystallinity, clean and smooth surfaces and excellent superconducting properties. It is also suitable for preparing a layered structure including an oxide superconductor layer and a insulator layer.

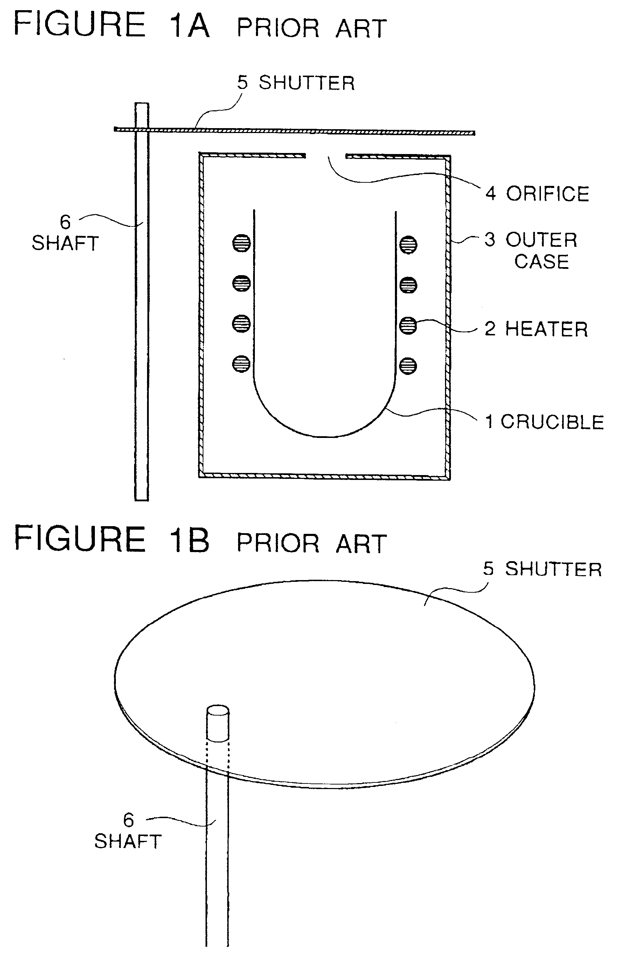

In the above MBE method and reactive evaporation method, molecular beams are emitted by vapor sources called K cells. A K cell is a vapor source of crucible type comprising a small orifice at the top through which a molecular beam is emitted and a shutter to open and close the orifice. The molecular beam is controlled by opening and closing of the shutter. There is shown a sectional view of a conventional K cell in Figure 1A. The K cell shown in Figure 1A comprises a crucible 1 of refractory material, a heater 2 surrounding the crucible 1 for heating the crucible 1, an outer case 3 containing the crucible 1 and heater 2 and having a small orifice at the top, and a shutter 5 to substantially open and close the orifice 4. Figure 1B shows a perspective view of the shutter 5. As shown in Figure 1B, the shutter 5 is formed of a stainless steel disc member having a diameter larger than that of the outer case 3 and rotatable centered on a shaft 6.

The crucible 1 of the K cell can be heated by induction heating. In this case, the heater 2 may be omitted. The outer case 3 may also be omitted if a lid having a small orifice is directly put on the crucible 1.

In the above conventional K cell, thermal conditions are changed depending on opening and closing of the shutter, which causes inconvenience. When the shutter is closed, the K cell radiates little heat so that crucible temperature becomes higher, whereas it radiates much heat so that crucible temperature is lowered when the shutter is opened.

As explained above, intensity of a molecular beam is determined by crucible temperature of a K cell. Therefore, it takes long time to stabilize intensity of a molecular beam after a shutter of a K cell is opened. When a thin film is accurately formed by switching different K cells from one to another to stack atomic layers layer by layer, deposition should be interrupted by masking a substrate until a molecular beam is stabilized after a K cell is switched from another one. During the interruption, a chemically active growing surface of the thin film is exposed so that impurities may adhere on the growing surface. Therefore, it is difficult to form a thin film having high purity by using a conventional K cell.

### Summary of the Invention

Accordingly, it is an object of the present invention to provide a novel K cell type vapor source which has overcome the above mentioned defect of the conventional one.

Another object of the present invention to provide a novel shutter for K cell type vapor source which has overcome the above mentioned defect of the conventional one.

The above and other objects of the present invention are achieved in accordance with the present invention by a K cell type vapor source used for film deposition by a MBE method and a reactive co-evaporation comprising a crucible, a small orifice above the crucible through which the crucible emits a molecular beam, and a shutter which substantially opens and closes the small orifice so as to control the molecular beam wherein the crucible radiates sufficient heat so as to prevent overheating when the shutter is closed so that the crucible emits a stable molecular beam immediately after the shutter is opened.

According to a preferred embodiment of the present invention, the shutter comprises a louver through which the crucible radiates sufficient heat.

According to another preferred embodiment of the present invention, the shutter can comprise an opening at its center portion and a roof member above the opening through which the crucible radiates sufficient heat. In this case, it is also preferable that the shutter further comprises a cold trap surrounding the opening.

According to another aspect of the present invention, there is provided a shutter for K cell type vapor source, the K cell type vapor source is used for film deposition by a MBE method and a reactive co-evaporation and comprises a crucible and a small orifice above the crucible through which the crucible emits a molecular beam, and the shutter substantially opens and closes the small orifice so as to control the molecular beam wherein the crucible radiates sufficient heat so as to prevent overheating when the shutter is closed so that the crucible emits a stable molecular beam immediately after the shutter is opened.

The shutter preferably comprises a louver through which the crucible radiates sufficient heat. It is also preferable that the shutter comprises an opening at its center portion and a roof member above the opening through which the crucible radiates sufficient heat. The shutter can further comprise a cold trap surrounding the opening.

The above and other objects, features and advantages of the present invention will be apparent from the following description of preferred embodiments of the invention with reference to the accompanying drawings.

### Brief Description of the Drawings

Figure 1A is a sectional view of a conventional K cell as explained above;
Figure 1B is a perspective view of a shutter of the K cell shown in Figure 1A;
Figure 2A is a sectional view of an embodiment of the K cell in accordance with the present invention;
Figure 2B is a perspective view of a shutter of the K cell shown in Figure 2A;
Figure 3 is a graph of total amounts of deposition against time by using the conventional K cell shown in Figures 1A and 1B and the K cell in accordance with the present invention shown in Figures 2A and 2B;
Figure 4A is a sectional view of another embodiment of the K cell in accordance with the present invention; and
Figure 4B is a perspective view of a shutter of the K cell shown in Figure 4A.

### Description of the Preferred embodiments

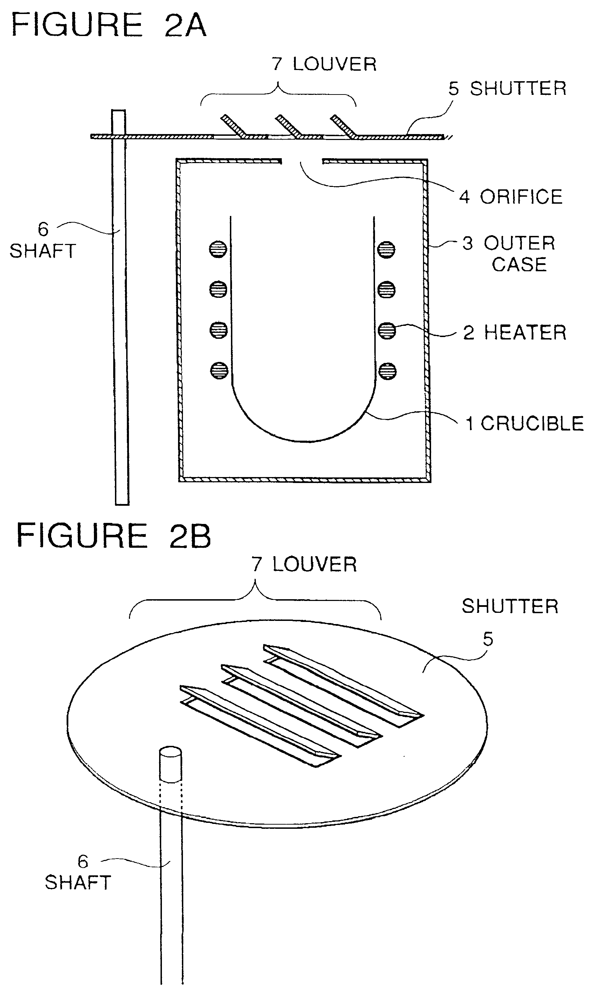

Referring to Figures 2A and 2B, a first embodiment of the K cell in accordance with the present invention will be explained. The K cell shown in Figures 2A and 2B comprises a crucible 1 of refractory material, a heater 2 surrounding the crucible 1 for heating the crucible 1, an outer case 3 containing the crucible 1 and heater 2 and having a small orifice at the top, and a shutter 5 to substantially open and close the orifice 4, similarly to the conventional K cell shown in Figures 1A and 1B. The crucible 1 can be formed of a refractory material which does not release much gas under ultra high vacuum of the order of 10⁻⁸ Torr or higher such as graphite, boron nitride, etc. The shutter 5 is formed of a disc member, for example of stainless steel, comprising a louver 7 and having a diameter larger than that of the outer case 3. The shutter 5 is rotatable centered on a shaft 6. The crucible 1, outer case 3, orifice 4 and shutter 5 are coaxially arranged when the shutter is at a close position. The crucible 1 of the K cell can be heated by induction heating. In this case, the heater 2 may be omitted. The outer case 3 may also be omitted if a lid having a small orifice is directly put on the crucible 1.

There is a temperature distribution in crucible 1, in which the center of crucible 1 is at a higher temperature and peripheral portions are at lower temperatures. The louver 7 is configured so as to radiate sufficient heat from the crucible 1 in particular from its center portion but to cut off a molecular beam when the shutter 5 is closed. Therefore, the shutter 5 comprising the louver 7 prevents the crucible 1 from overheating and the temperature distribution in crucible 1 from increasing when the shutter 5 is closed. This enables to emit a stable molecular beam immediately after the shutter 5 is opened.

In Figures 2A and 2B, the louver 7 comprises three louver board. However, a distance between the orifice 4 and the shutter 5 a configuration and dimension of the louver 7 and a number of louver board should be appropriately selected in consideration of temperatures of the crucible 1 and a deposition material. In any case, the louver 7 should be designed to cut off a molecular beam when the shutter 5 is closed.

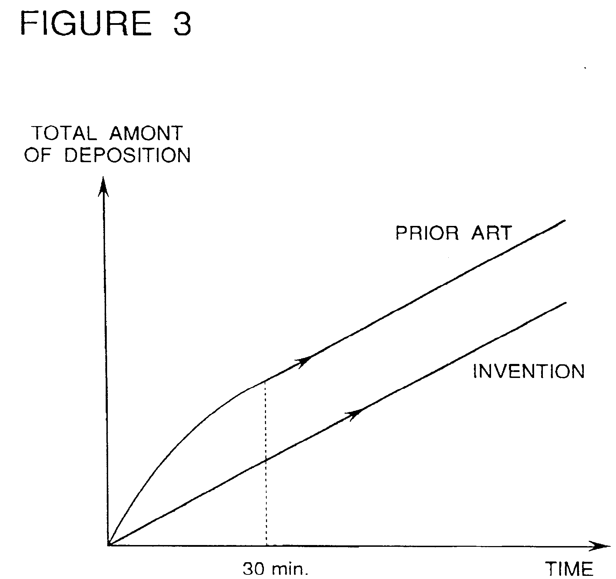

Figure 3 shows a graph of total amounts of deposition against time since opening of shutters by using the conventional K cell shown in Figures 1A and 1B and the K cell in accordance with the present invention shown in Figures 2A and 2B. Namely, a gradient of a line indicates a deposition rate. As shown in Figure 3, the conventional K cell emits a more intensive molecular beam (large deposition rate) for about 30 minutes immediately after the shutter is opened. After an elapse of 30 minutes, the molecular beam becomes stable (constant deposition rate) and deposition linearly progresses. Therefore, it is difficult to accurately control the amount of deposition.

However, the K cell in accordance with the present invention emits a constant molecular beam so that deposition linearly progresses from opening of the shutter. In other words, a deposition rate is constant from opening of the shutter. Therefore, it is possible to accurately control the amount of deposition.

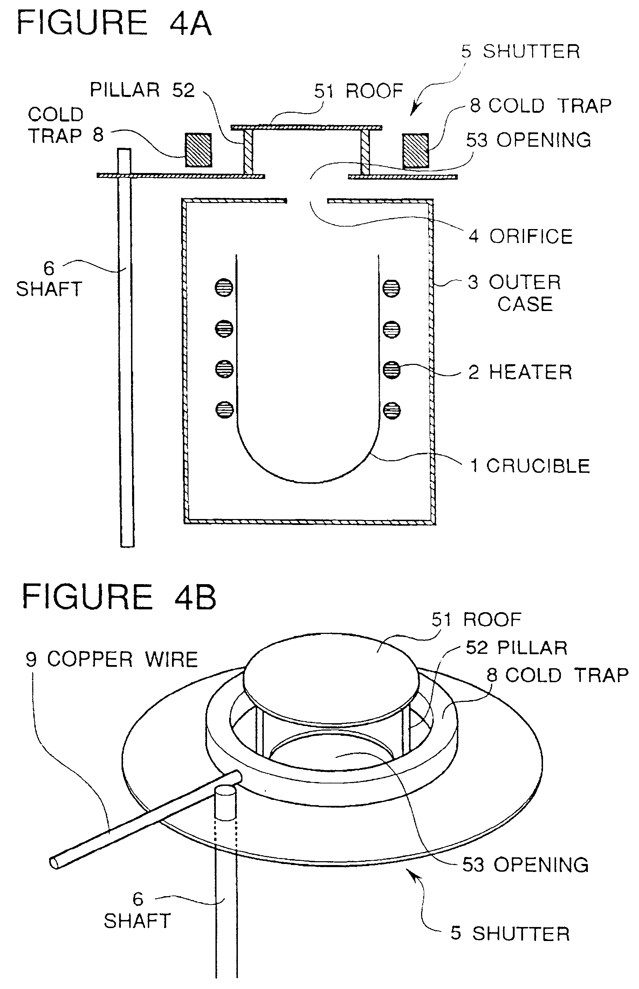

There is shown another embodiment of the K cell in accordance with the present invention in Figures 4A and 4B. Figure 4A shows a sectional view of the K cell similarly to Figures 1A and 2A and Figure 4B shows perspective view of a shutter similarly to Figures 1B and 2B. The K cell shown in Figures 4A and 4B comprises a crucible 1 of refractory material, a heater 2 surrounding the crucible 1 for heating the crucible 1, an outer case 3 containing the crucible 1 and heater 2 and having a small orifice at the top, and a shutter 5 to substantially open and close the orifice 4, similarly to the conventional K cell shown in Figures 1A and 1B. The crucible 1 can be formed of a refractory material which does not release much gas under ultra high vacuum of the order of 10⁻⁸ Torr or higher such as graphite, boron nitride, etc. The shutter 5 is formed of a disc member, for example of stainless steel, comprising an opening 53 at its center portion and a roof 51 supported by pillars 52 above the opening 53 and having a larger diameter than the outer case 3, and is rotatable centered on a shaft 6. The shutter 5 also comprises a cold trap 8 around the opening 53. The cold trap 8 is formed of a copper ring and a copper wire 9 is connected at one side, which is prolonged to a liquid nitrogen bath (not shown). The cold trap 8 chilled by liquid nitrogen through the copper wire. The crucible 1, outer case 3, orifice 4, shutter 5, and the opening 53, roof 51 and cold trap 8 of the shutter 5 are coaxially arranged when the shutter 5 is at a close position. The crucible 1 of the K cell can be heated by induction heating. In this case, the heater 2 may be omitted. The outer case 3 may also be omitted if a lid having a small orifice is directly put on the crucible 1.

There is a temperature distribution in crucible 1, in which the center of crucible 1 is at a higher temperature and peripheral portions are at lower temperatures. The opening 53, roof 51 and cold trap 8 of the shutter 5 are configured so that the cold trap 8 can absorb sufficient heat radiated from the crucible 1 in particular from its center portion but to cut off a molecular beam when the shutter 5 is closed. Therefore, the shutter 5 prevents the crucible 1 from overheating and the temperature distribution in crucible 1 from increasing when the shutter 5 is closed. This enables to emit a stable molecular beam immediately after the shutter 5 is opened. If the crucible 1 can radiate sufficient heat and there is little leak of a molecular beam when the shutter 5 is closed, the cold trap 8 is not necessary.

In this embodiment, the cold trap 8 is formed of a copper ring. However, a distance between the orifice 4 and the shutter 5, a configuration and dimension of the opening 53, roof 51 and cold trap 8, and a thermal capacity of the cold trap 8 should be appropriately selected in consideration of temperatures of the crucible 1 and a deposition material. In any case, the opening 53 and roof 51 should be designed to cut off a molecular beam when the shutter 5 is closed.

The invention has thus been shown and described with reference to the specific embodiments. However, it should be noted that the present invention is in no way limited to the details of the illustrated structures but changes and modifications may be made within the scope of the appended claims.

## Claims

1. A K cell type vapor source used for film deposition by a MBE method and a reactive co-evaporation comprising a crucible, a small orifice above the crucible through which the crucible emits a molecular beam, and a shutter which substantially opens and closes the small orifice so as to control the molecular beam wherein the crucible radiates sufficient heat so as to prevent overheating when the shutter is closed so that the crucible emits a stable molecular beam immediately after the shutter is opened.

2. A K cell type vapor source as claimed in Claim 1, wherein the shutter comprises a louver through which the crucible radiates sufficient heat.

3. A K cell type vapor source as claimed in Claim 1, wherein the shutter comprises an opening at its center portion and a roof member above the opening through which the crucible radiates sufficient heat.

4. A K cell type vapor source as claimed in Claim 3, wherein the shutter further comprises a cold trap surrounding the opening.

5. A shutter for K cell type vapor source, the K cell type vapor source is used for film deposition by a MBE method and a reactive co-evaporation and comprises a crucible and a small orifice above the crucible through which the crucible emits a molecular beam, and the shutter substantially opens and closes the small orifice so as to control the molecular beam wherein the crucible radiates sufficient heat so as to prevent overheating when the shutter is closed so that the crucible emits a stable molecular beam immediately after the shutter is opened.

6. A shutter as claimed in Claim 5, wherein the shutter comprises a louver through which the crucible radiates sufficient heat.

7. A shutter as claimed in Claim 5, wherein the shutter comprises an opening at its center portion and a roof member above the opening through which the crucible radiates sufficient heat.

8. A shutter as claimed in Claim 7. wherein the shutter further comprises a cold trap surrounding the opening.
